# EUROPÄISCHE PATENTSCHRIFT

(11) **EP 0 905 275 B1**
(45) Veröffentlichungstag und Bekanntmachung des Hinweises auf die Patenterteilung: **01.10.2003**
(21) Anmeldenummer: 98116348.8
(22) Anmeldetag: 28.08.1998
(51) Int. Cl.: C23C 14/56, C23C 14/50, C23C 14/34

(54) **Vorrichtung zum Beschichten eines im wesentlichen flachen scheibenförmigen Substrats**
Apparatus for coating an essentially flat, disc-shaped substrate
Dispositif pour revêtir un substrat essentiellement plat en forme de disque

(30) Priorität: 29.09.1997 DE 19742923
(43) Veröffentlichungstag der Anmeldung: 31.03.1999
(73) Patentinhaber: Unaxis Deutschland Holding GmbH, 81476 München (DE)
(72) Erfinder: König, Michael, 60529 Frankfurt (DE)

(56) Entgegenhaltungen:
- EP-A- 0 344 823
- EP-A- 0 448 782
- US-A- 4 226 208
- US-A- 4 820 106
- US-A- 5 266 119
- US-A- 5 407 314

## Beschreibung

Die Erfindung betrifft eine Vorrichtung zum Beschichten eines im wesentlichen flachen, scheibenförmigen Substrats mit Hilfe der Kathodenzerstäubung/ mit einer etwa kreiszylindrischen Transportkammer, bestehend aus einem kreisscheibenförmigen Deckel, einer sich zu diesem in einer parallelen Ebene erstreckenden Bodenplatte und einem beide Teile druckfest verbindenden und mit Abstand zueinander haltenden, ringförmigen, die Seitenwand bildenden Gehäuseteil und mit einer an die Transportkammer angeschlossenen Vakuumpumpe und mit einer im Deckel der Transportkammer vorgesehenen, von einer Platte verschließbaren Öffnung zum Einund Ausschleusen der Substrate und mit einer mit dem Deckel verbundenen, die Kathode enthaltenden durch eine Öffnung im Deckel mit dem Transportraum verbundenen Beschichtungskammer und einem in der Transportkammer rotierbar gelagerten Substratträger.

Es ist eine Vorrichtung der in Frage stehenden Art bekannt (US 3,874,525), die eine Beschichtungskammer aufweist, in der ein zweiarmiges Greifwerkzeug um eine vertikale Achse drehbar gelagert ist. Dieses zweiarmige Werkzeug weist an seinen einander diametral gegenüberliegenden Enden Gabeln auf, die mit Hilfe eines Zahnstangengetriebes mit Antriebsmotor in vertikaler Ebene gegenläufig zueinander bewegbar sind. Weiterhin sind zwei Konsolen in der Beschichtungskammer angebracht, von denen die eine unterhalb einer Schleuse im Deckel der Beschichtungskammer angeordnet ist und die andere auf der dieser Konsole gegenüberliegenden Seite unterhalb der Elektronenkanone.

Diese bekannte Vorrichtung hat den Nachteil, daß das zweiarmige Greifwerkzeug vergleichsweise aufwendig ausgebildet ist und auch wenig zuverlässig arbeitet, da der komplizierte Zahntrieb Abrieb erzeugt. Weiterhin besteht bei dieser Vorrichtung die Gefahr, daß das Werkstück nicht einwandfrei vom gabelförmigen Werkzeug erfaßt wird und dann entweder verkantet aufgenommen wird oder aber sich vollständig vom Werkzeug löst und dann auf die Bodenfläche der Beschichtungskammer fällt, was zwangsläufig zu einer Blockade bzw. zum Ausfall der gesamten Anlage führt. Schließlich benötigt die bekannte Vorrichtung eine große Bauhöhe, was eine unerwünscht voluminöse Beschichtungskammer erforderlich macht.

Bekannt ist auch eine Vorrichtung der in Frage stehenden Art (US 4,548,699), bei der eine etwa kreiszylindrische Beschichtungskammer vorgesehen ist, bestehend aus einem kreisscheibenförmigen Deckel und einer eben solchen Bodenplatte, wobei Deckel und Bodenplatte mit einem hohlzylindrischen bzw. ringförmigen Seitenteil fest verbunden sind und bei der in der Beschichtungskammer ein kreisscheibenförmiger Drehteller zur Halterung und Führung der Substrate und eine weitere Druckplatte angeordnet sind, die im übrigen in Richtung auf den Deckel zu verschiebbar sind und nach dem Verschieben zusammen mit dem Deckel eine im Deckel vorgesehene Einschleusöffnung druckfest verschließen. Diese bekannte Vorrichtung weist einen komplizierten Aufbau auf und arbeitet relativ langsam, insbesondere da die Wafer von federnden Elementen übernommen werden müssen und die Einschleusöffnung durch eine zusätzliche Verschlußplatte, die um einen sich quer zur Rotationsachse angeordneten Bolzen schwenkt, verschlossen werden muß.

Bekannt ist auch eine Vorrichtung zum Ein- und Ausschleusen eines im wesentlichen flachen Werkstücks (DE 37 16 498) in eine evakuierte, im wesentlichen kreiszylindrische, aus einem flachen, kreisscheibenförmigen Deckel und einem sich zu diesem in einer parallelen Ebene erstreckenden flachen, kreisscheibenförmigen Bodenplatte und einem beide Teile druckfest verbindenden und im Abstand zueinander haltenden ringförmigen Seitenteil gebildete Beschichtungskammer mit einem in der Beschichtungskammer rotierbar gelagerten kreisscheibenförmigen Drehteller zur Halterung der Werkstükke während des Beschichtungsprozesses, wobei die Vorrichtung zum Zuführen und Rückführen des Werkstücks in und aus dem Bereich einer am Deckel der Beschichtungskammer angeordneten Beschichtungsquelle zum Zwecke der Behandlung der Werkstückoberfläche dient, wobei eine auf dem Deckel der Beschichtungskammer angeordnete Beschichtungsvorrichtung mit einem oder mehreren deckelförmigen Werkstückträgern mit Hilfe derer die Werkstücke in eine einer Öffnung der Beschichtungskammer benachbarten Position bringbar sind, von der aus die Öffnung von oben her vom Werkstückträger und von unten her von einem Hubteller verschließbar ist, der auf einem innerhalb der Beschichtungskammer rotierbar gelagerten Drehteller gehalten und geführt ist, wobei der Werkstückträger von einem sich an der Beschichtungsvorrichtung abstützenden Hubzylinder und der Hubteller von einer an der Bodenplatte befestigten Hubvorrichtung an den Deckel der Beschichtungskammer anpreßbar sind.

Schließlich ist eine Vakuumbeschichtungsanlage zum Aufdampfen dünner Schichten auf Substrate bekannt (US 3,915,117), mit einer Eintrittskammer, weiteren Kammern zur Behandlung bzw. Beschichtung der Substrate und mit einer Austrittskammer sowie mit einer in einer evakuierbaren Hauptkammer angeordneten Fördereinrichtung zum Transport der Substrate durch die Kammern, wobei Abdichteinrichtungen zur zeitweisen Abdichtung zwischen den genannten Kammern und der Hauptkammer vorgesehen sind, wobei die Fördereinrichtung um eine gemeinsame Achse herum angeordnete und um diese schwenkbare Rahmen für die Aufnahme des zu beschichtenden Gutes aufweist, wobei in wenigstens zwei Behandlungspositionen, nämlich einer Ein- und Austrittsposition und einer Aufdampfposition ein solcher Rahmen selbst Teil der Wand einer Behandlungskammer, nämlich der Ein- und Austrittskammer und einer Aufdampfkammer bildet und daß in mindestens einer dieser Behandlungspositionen eine bewegliche Ventilplatte zum Absperren einer Stirnseite des einen Teils der Behandlungskammer bildenden Rahmens vorgesehen ist.

Der vorliegenden Erfindung liegt die Aufgabe zugrunde eine Vorrichtung des in Frage stehenden Typs so auszubilden, daß die Zeit zum Wechseln der Kathode auf ein Minimum verkürzbar ist. Darüber hinaus soll die Vorrichtung einfacher im Aufbau und damit auch preiswerter in der Herstellung und auch betriebssicherer sein. Schließlich soll das von der Vorrichtung beanspruchte Bauvolumen dadurch verringert werden, daß insbesondere auf zusätzliche Antriebe im Umfangsbereich der Transportkammer verzichtet wird.

Diese Aufgabe wird erfindungsgemäß dadurch gelöst, daß der Substratträger mit der Abtriebswelle einer Motor-Getriebeeinheit verbunden ist und zum einen von dieser innerhalb des Transportraums aus einer mittleren Betriebsposition in einer vertikalen Hubbewegung in eine obere Beschichtungsposition und eine untere Ruheposition verschiebbar ist und zum anderen mit der Abtriebswelle innerhalb des Transportraums rotierbar ist, wobei der Saugstutzen der Vakuumpumpe am Bodenteil der Transportkammer angeordnet ist und vom Substratträger in der Ruheposition verschließbar ist.

Weitere Einzelheiten und Merkmale sind in den Patentansprüchen näher beschrieben und gekennzeichnet.

Die Erfindung läßt die verschiedensten Ausführungsmöglichkeiten zu; eine davon ist in den anhängenden Zeichnungen rein schematisch näher dargestellt und zwar zeigen:
- Fig. 1: Die Vorrichtung in der Seitenansicht und teilweise im Schnitt, wobei der Substratträger in seiner mittleren, d. h. in der Transportposition innerhalb der Transportkammer gezeigt ist,
- Fig. 2: die Transportkammer nach Fig. 1, jedoch mit dem Substratträger in der oberen bzw. in der Einschleus- und Beschichtungsposition und
- Fig. 3: die Transportkammer nach Fig. 1, jedoch mit dem Substratträger in der unteren, d. h. in der Sperr- bzw. Ruheposition.

Die Vorrichtung zum Beschichten von Substraten 3 besteht im wesentlichen aus der Transportkammer 7 mit dem in dieser drehbar angeordneten Substratträger 12 mit Substrataufnahmen 17, 18, der Beschichtungskammer 11 mit der der in dieser angeordneten Zerstäubungskathode 10, der Verschlußplatte 16 zum Verschließen der Schleusenöffnung 9 im Deckel 4 der Transportkammer 7, der Motor-Getriebeeinheit 14 für die Antriebswelle 13 auf der der Substratträger 12 drehfest aufgesetzt ist und der Vakuumpumpe 8 deren Saugstutzen 15 mit dem Transportraum 19 verbunden ist.

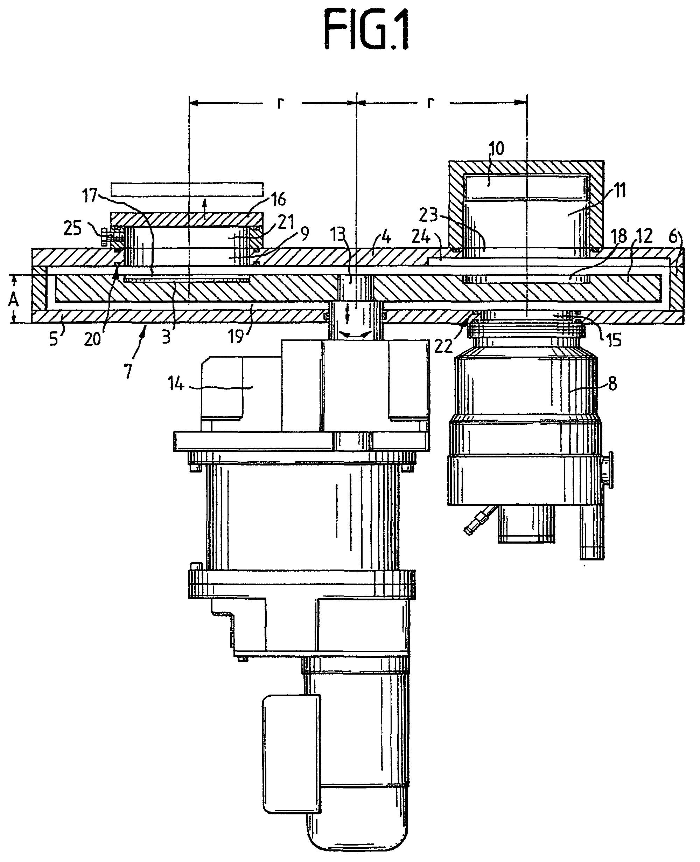

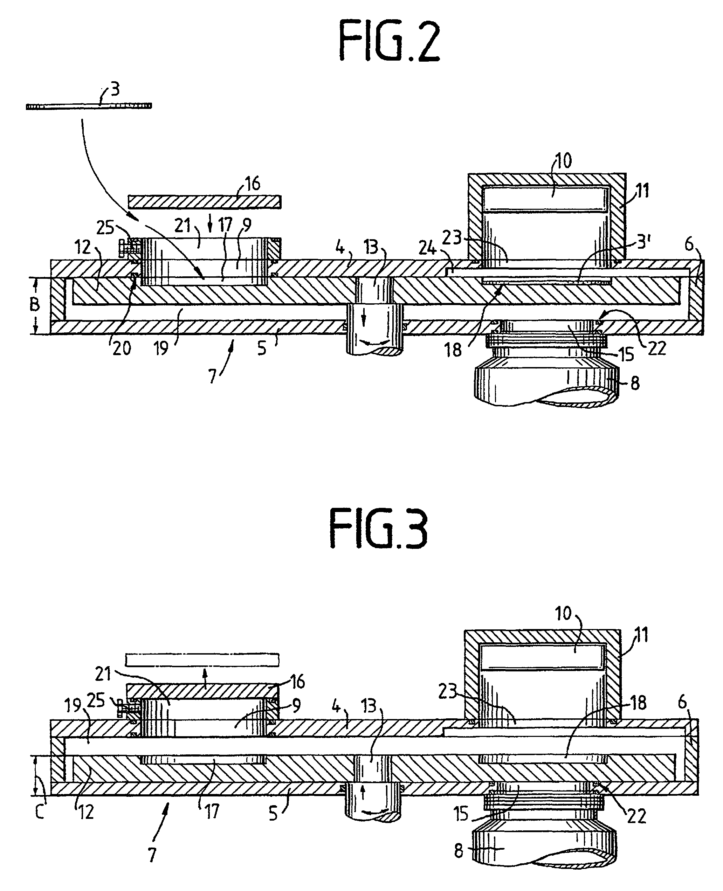

Für das Einschleusen bzw. das Ausschleusen des Substrats 3 und auch für den Beschichtungsvorgang wird der Substratträger 12 mittels der Motor-Getriebeeinheit 14 in die in Fig. 2 dargestellte Position B gefahren, in der sich der Substratträger 12 mit seiner Oberseite auf die Dichtung 20 legt und damit den Transportraum 19 von der Einschleuskammer 21 abkoppelt bzw. die Öffnung 9 im Deckel 4 der Transportkammer 7 verschließt. Nach Erreichen der Position B kann auch ein weiteres - bereits vorher eingeschleustes - Substrat 3' beschichtet werden, das sich in einer der Substrataufnahme 17 gegenüberliegend angeordneten Substrataufnahme 18 befindet und dabei genau unterhalb der Kathode 10 positioniert ist. Wie Fig. 2 weiter zeigt, wird die Platte 16 zum Einschleusen (bzw. zum Ausschleusen) von der Einschleuskammer 21 abgehoben bzw. von dieser entfernt, so daß ein Substrat 3 eingeschleust bzw. ausgeschleust werden kann. Nach dem Ein- bzw. Ausschleusen kann die Schleusenkammer 21 wieder mit Hilfe der Platte 16 verschlossen werden und der Substratträger 12 kann anschließend in die in Fig. 1 gezeigte Position A abgesenkt und danach gedreht werden, so daß das zuletzt eingeschleuste Substrat 3'... die Beschichtungsposition erreicht. Um die Kathode 10 bzw. deren Target (das zerstäubt wird) wechseln zu können, ohne daß die an den Transportraum 19 angeschlossene und diesen evakuierende Vakuumpumpe 8 abgeschaltet werden muß, kann der Substratträger 12 in die Position C abgesenkt werden (Position C), wobei sich die Unterseite des Substratträgers 12 auf die Dichtung 22 aufsetzt und den Saugstutzen 15 absperrt, was für die laufende Vakuumpumpe 8 problemlos ist. Nach dem Absenken in die Position C (Fig. 3) kann die Beschichtungskammer 11 von der Transportkammer 7 entfernt bzw. geöffnet werden und die Kathode 10 kann durch eine andere ersetzt werden. Nach dem Kathodenwechsel und dem Aufsetzen bzw. Schließen der Beschichtungskammer 11 kann der Substratträger 12 in die Betriebsstellung gemäß Fig. 1 gehoben werden, so daß die Verbindung der immer noch laufenden Vakuumpumpe 8 mit dem Transportraum 19 wiederhergestellt ist.

Ein besonderer Vorteil der Vorrichtung besteht darin, daß vor dem Kathodenwechsel die Vakuumpumpe 8 nicht abgeschaltet und nach erfolgtem Kathodenwechsel nicht wieder angeschaltet werden muß - ein Vorgang der vergleichsweise längere Zeit beansprucht, insbesondere wenn eine Hochvakuumpumpe (Turbomolekularpumpe) Verwendung findet. Einen weiteren Vorteil bietet die kompakte Motor-Getriebeeinheit, die sowohl für die Drehbewegung des Substratträgers 12, als auch für die Hubbewegung Sorge trägt.

### Bezugszeichenliste

- 3, 3': Substrat
- 4: Deckel
- 5: Bodenplatte
- 6: Seitenwandteil
- 7: Transportkammer
- 8: Vakuumpumpe
- 9: Öffnung, Schleusenöffnung
- 10: Kathode
- 11: Beschichtungskammer
- 12: Substratträger
- 13: Antriebswelle
- 14: Motor-Getriebeeinheit
- 15: Saugstutzen
- 16: Platte, Verschlußplatte
- 17: Substrataufnahme
- 18: Substrataufnahme
- 19: Transportraum
- 20: Dichtung
- 21: Schleusenkammer
- 22: Dichtung
- 23: Öffnung
- 24: Kanal
- 25: Vakuumpumpenanschluß

## Patentansprüche

1. Vorrichtung zum Beschichten eines im wesentlichen flachen, scheibenförmigen Substrats (3, 3', ...) mit Hilfe der Kathodenzerstäubung, mit einer etwa kreiszylindrischen Transportkammer (7), bestehend aus einem kreisscheibenförmigen Deckel (4), einer sich zu diesem in einer parallelen Ebene erstreckenden Bodenplatte (5) und einem beide Teile druckfest verbindenden und mit Abstand zueinander haltenden, ringförmigen, die Seitenwand der Transportkammer (7) bildenden Gehäuseteil (6) und mit einer an die Transportkammer (7) angeschlossenen Vakuumpumpe (8) und mit einer im Deckel (4) der Transportkammer (7) vorgesehenen, von einer Platte (16) verschließbaren Öffnung (9) zum Ein- und Ausschleusen der Substrate (3, 3', ...) und mit einer mit dem Deckel (4) verbundenen, die Kathode (10) enthaltenden durch eine Öffnung (23) im Deckel (4) mit dem Transportraum (19) verbundenen Beschichtungskammer (11) und einem im Transportraum (19) rotierbar gelagerten Substratträger (12), **dadurch gekennzeichnet, daß** der Substratträger (12) mit der Abtriebswelle (13) einer Motor-Getriebeeinheit (14) verbunden ist und zum einen von dieser innerhalb des Transportraums (19) aus einer mittleren Betriebsposition (A) in einer vertikalen Hubbewegung in eine obere Beschichtungsposition (B) und eine untere Ruheposition (C) verschiebbar ist und zum anderen von der Abtriebswelle (13) innerhalb des Transportraums (19) rotierbar ist, wobei der Saugstutzen (15) der Vakuumpumpe (8) am Bodenteil (4) des Transportraums (19) angeordnet ist und vom Substratträger (12) in der Ruheposition (C) verschließbar ist.

2. Vorrichtung nach Anspruch 1, **dadurch gekennzeichnet, daß** die Öffnung (9) zum Ein- und Ausschleusen der Substrate (3, 3', ...) im Deckel (4) der Transportkammer (7) oder eine mit ihr korrespondierende Schleusenkammer (21) mit einem Anschluß (25) für eine Vakuum-Vorpumpe versehen ist.

3. Vorrichtung nach Anspruch 1, **dadurch gekennzeichnet, daß** die Öffnung (23) im Deckel (4) für die Beschichtungskammer (11) über einen einen Bypass bildenden Kanal (24) mit dem Transportraum (18) verbunden ist.

4. Vorrichtung nach Anspruch 1, **dadurch gekennzeichnet, daß** die Beschichtungskammer (11) mit der Transportkammer (7) lösbar verbunden ist.

## Claims

1. Device for coating a substantially flat, disk-shaped substrate (3, 3', ...) with the aid of cathode sputtering, having an approximately circular cylindrical transport chamber (7), comprising a circular disk-shaped cover (4), a base plate (5) extending in a plane parallel to it and an annular housing member (6) comprising the side wall of the transport chamber (7) connecting these two members in airtight manner and holding them at a distance from each other, and with a vacuum pump (8) connected to the transport chamber (7) and with an opening (9) provided in the cover (4) of the transport chamber (7), closable by a plate (16), for introducing and removing the substrate (3, 3', ...) and with a coating chamber (11) connected to the cover (4) and containing the cathode (10) and connected through an opening (23) in the cover (4) to the transport chamber (19), and with a substrate support (12) rotatably mounted in the transport chamber (19), **characterised in that** the substrate support (12) is linked to the drive shaft (13) of a motor-gearbox unit (14) and, on the one hand, is displaceable by this within the transport chamber (19) from a central operating position (A) in a vertical lifting movement into an upper coating position (B) and a lower rest position (C) and, on the other hand, is rotatable by the drive shaft (13) within the transport chamber (19), whereby the suction port (15) of the vacuum pump (8) is arranged on the base member (4) of the transport chamber (19) and may be closed by the substrate support (12) in the rest position (C).

2. Device according to Claim 1, **characterised in that** the opening (9) for introducing and removing the substrates (3, 3', ...) is provided in the cover (4) of the transport chamber (7) or an airlock chamber (21) corresponding with it, said airlock chamber having a connection (25) for a vacuum pump.

3. Device according to Claim 1, **characterised in that** the opening (23) in the cover (4) for the coating chamber (11) is connected to the transport chamber (19) via a channel (24) comprising a bypass.

4. Device according to Claim 1, **characterised in that** the coating chamber (11) is detachably connected to the transport chamber (7).

## Revendications

1. Dispositif de revêtement d'un substrat (3, 3', ...), essentiellement plat et en forme de disque par pulvérisation cathodique,
qui comporte une chambre de transport (7) à peu près cylindrique circulaire, composée d'un couvercle (4) discoïdal, d'une plaque de fond (5) s'étendant suivant un plan parallèle à ce dernier et d'un élément de carter (6) de forme annulaire constituant la paroi latérale de la chambré de transport (7) et assurant une liaison résistant à la pression entre les deux parties ainsi que l'espacement de l'une par rapport à l'autre,
et qui comporte aussi une pompe à vide (8) raccordée à la chambre de transport (7) et un orifice (9), ménagé dans le couvercle (4) de la chambre de transport (7) et obturable par une plaque (16), pour faire sas d'entrée et sortie des substrats (3, 3', ...).
et qui comporte en outre une chambre de revêtement (11) liée au couvercle (4), renfermant la cathode (10) et communicant avec l'espace de transport (19) par une ouverture (23) à travers le couvercle (4),
ainsi qu'un support de substrat (12) monté rotatif à l'intérieur de l'espace de transport (19),
**caractérisé en ce que** le support de substrat (12) est relié à l'arbre de sortie (13) d'un bloc-moteur (14) et **en ce qu'**il peut d'une part être entraîné par ce dernier en translation à l'intérieur de l'espace de transport (19), à partir d'une position centrale de service (A) en course verticale vers une position supérieure (B) de revêtement ou une position inférieure (C) de repos, et d'autre part être entraîné en rotation à l'intérieur de l'espace de transport (19) par l'arbre de sortie (13),
le raccord d'aspiration (15) de la pompe à vide (8) étant agencé au niveau de la plaque de fond (5) de l'espace de transport (19) et pouvant ainsi être fermé par le support de substrat (12) en position de repos (C).

2. Dispositif selon la revendication 1, **caractérisé par** un raccord (25) pour pompe à vide préliminaire dont est pourvu soit l'orifice (9) formant sas d'entrée et sortie des substrats (3, 3', ...) dans le couvercle (4) de la chambre de transport (7), soit une chambre de sas (21) correspondante communicant avec la chambre de transport (7).

3. Dispositif selon la revendication 1. **caractérisé en ce que** l'ouverture (23) dans le couvercle (4) vers la chambre de revêtement (11) est reliée à l'espace de transport (19) par un canal (24) de dérivation.

4. Dispositif selon la revendication 1, **caractérisé en ce que** la chambre de revêtement (11) est liée à la chambre de transport (7) de façon amovible.
